# FASCICULE DE BREVET EUROPEEN

(11) **EP 1 516 368 B1**
(45) Date de publication et mention de la délivrance du brevet: **23.01.2008**
(21) Numéro de dépôt: 03760788.4
(22) Date de dépôt: 25.06.2003
(51) Int. Cl.: H01L 27/146, H01L 31/02

(54) **IMAGEUR**
ABBILDUNGSVORRICHTUNG
IMAGER

(30) Priorité: 25.06.2002 FR 0207893; 25.06.2002 FR 0207894
(43) Date de publication de la demande: 23.03.2005
(73) Titulaire: COMMISSARIAT A L'ENERGIE ATOMIQUE, 75015 Paris (FR); CENTRE NATIONAL DE LA RECHERCHE SCIENTIFIQUE (CNRS), 75794 Paris Cedex 16 (FR)
(72) Inventeur: Guedj, Cyril, F-38760 Varces Allieres et Risset (FR); ALVAREZ, José, F-75005 Paris (FR); BONNASSIEUX, Yvan, F-75013 Paris (FR); KLEIDER, Jean-Paul, F-91440 Bures sur Yvette (FR); MOUSSY, Norbert, F-38190 Sainte Agnes (FR); ROCA I CABARROCAS, Péré, F-91140 Villebon sur Yvette (FR); TCHAKAROV, Svetoslav, 94110 Arceuil (FR)
(74) Mandataire: Poulin, Gérard
(86) Numéro de dépôt international: PCT/FR2003/001965
(87) Numéro de publication internationale: WO 2004/001853

(56) Documents cités:
- EP-A- 0 726 605
- EP-A- 1 050 907
- US-A- 6 018 187
- VOZ C ET AL: "Thin-film transistors with polymorphous silicon active layer" JOURNAL OF NON-CRYSTALLINE SOLIDS, NORTH-HOLLAND PHYSICS PUBLISHING. AMSTERDAM, NL, vol. 299-302, avril 2002 (2002-04), pages 1345-1350, XP004353229 ISSN: 0022-3093
- POISSANT Y ET AL: "Metastability study and optimization of polymorphous silicon solar cells: the state-of-the-art" JOURNAL OF NON-CRYSTALLINE SOLIDS, NORTH-HOLLAND PHYSICS PUBLISHING. AMSTERDAM, NL, vol. 299-302, avril 2002 (2002-04), pages 1173-1178, XP004353196 ISSN: 0022-3093
- AFANAS'EV V P ET AL: "PHOTODETECTOR STRUCTURES BASED ON AMORPHOUS HYDROGENATED SILICON WITH NANOCRYSTALLINE INCLUSIONS" HUETTE. DES INGENIEURS TASCHENBUCH, XX, XX, vol. 68, no. 12, décembre 2001 (2001-12), pages 949-951, XP008017344
- FONTCUBERTA I MORRAL A ET AL: "In situ investigation of polymorphous silicon deposition" JOURNAL OF NON-CRYSTALLINE SOLIDS, NORTH-HOLLAND PUBLISHING COMPANY, AMSTERDAM, NL, vol. 266-269, mai 2000 (2000-05), pages 48-53, XP004198464 ISSN: 0022-3093

## Description

### DOMAINE TECHNIQUE

L'invention se situe dans le domaine des capteurs photosensibles, en particulier dans le domaine des longueurs d'onde visibles soit environ entre 400 et 800 nm et dans le domaine des longueurs d'onde ultraviolettes soit environ entre 10 et 400 nm. Ces capteurs comportent une couche éventuellement composée de plusieurs sous-couches d'un matériau photosensible convertissant les photons en charges électriques. Ces capteurs peuvent se présenter sous forme isolée ou sous forme d'un ensemble de capteurs constituant ensemble un imageur. L'invention concerne notamment les capteurs ou imageur à diodes PIN ou NIP.

### ETAT DE LA TECHNIQUE ANTERIEURE

Un capteur photosensible délivre un signal électrique dont l'amplitude est, dans une plage de fonctionnement, une fonction monotone croissante de l'intensité de la lumière qu'il reçoit. Les capteurs sont en général disposés sous forme d'une matrice de capteurs formées de une ou plusieurs colonnes et de une ou plusieurs lignes.

Les capteurs UV sont en général disposés sous forme de capteurs isolés destinés à détecter la présence de rayonnement UV ou d'un ensemble destiné à faire de l'imagerie UV.

Une matrice comportant plusieurs lignes et colonnes est employée dans la plupart des dispositifs de formation d'image. D'autres configurations sont connues, en particulier des configurations dans lesquelles les pixels sont arrangés en structure polygonales, c'est à dire des structures dans lesquelles les centres des pixels occupent les uns par rapport aux autres les sommets de polygones, par exemple des triangles ou des pentagones ou des hexagones réguliers. Ces structures sont employées en particulier pour augmenter le nombre de pixels par unité de surface ou pour réaliser des groupements de pixels sensibles à différentes couleurs ou à différentes longueurs d'onde. Les capteurs constituant ensemble un imageur sont couramment appelés "pixels" parce que chaque capteur délivre alors un signal électrique correspondant à un pixel d'une image à former.

Les références des documents de l'art antérieur qui seront cités dans la demande sont rappelées en fin de description avec le numéro entre crochets qui leur est attribué dans la présente description.

Le brevet US 6,114, 739 [1] décrit la forme général de capteurs photosensibles dont le matériau sensible est constitué par un matériau amorphe. Dans la description de l'art antérieur faite dans ce brevet, il est décrit une forme générale d'un ensemble de capteurs formant ensemble un imageur. Cette description est reprise ci après en relation avec la figue 1 annexée qui reproduit la figure 1 de ce brevet.

Cette figure représente une coupe transversale d'un réseau de capteurs comprenant un matériau sensible appelé également matériau actif.

Le réseau de capteurs est formé sur un substrat 10. Le substrat est généralement de type CMOS (complementary métal oxyde silicon) ou BiCMOS (bipolar complementary metal oxyde silicon) ou bipolaire. Le substrat peut également inclure une grande variété de technologies, incluant les technologies de type CCD (charge coupled devices).

Une structure d'interconnexion 12 connecte ce substrat à une couche 14 dopée n se trouvant au dessus de la structure d'interconnexion 12. Cette couche 14 sert à constituer, avec des couches intrinsèque I 16 et dopée p 18 empilées au dessus de la couche 14, un réseau de diodes PIN photodétectrices. La position des diodes formées à partir des couches 14, 16 et 18 est déterminée par la position de via conducteurs 20 formés en réseau matriciel dans la structure d'interconnexion 12.

Une couche conductrice translucide 24 est disposée au dessus du réseau matriciel de diodes PIN formées à partir des couche 14, 16, et 18. Cette couche 24 constitue une électrode de polarisation des diodes PIN.

La couche de substrat 10 inclut généralement un circuit de capture du signal délivré par chaque diode et des circuits d'adressage et de traitement analogique ou numérique de ces signaux.

Le fonctionnement est le suivant. Une tension de polarisation inverse est appliquée entre l'électrode formée par la couche 24 et le substrat 10. Le champ électrique ainsi créé, crée un courant correspondant au déplacement de charges électriques générées par les photons pénétrant le matériau actif. Le courant provenant des zones de matériau sensible qui se trouvent à l'aplomb d'un via 20 est dirigé préférentiellement par ce via 20 vers un circuit de capture de signal. Chacun des via 20 reçoit ainsi un courant qui est une fonction de l'éclairement reçu par la surface de matériau sensible se trouvant au dessus de ce via 20. Les différents signaux sont ensuite traités par les circuits d'adressage et de traitement inclus par exemple dans le substrat 10.

Comme expliqué dans le brevet US 6,114,739 [1], une limitation de la structure de capteur d'image qui vient d'être décrite provient du fait que les différents capteurs individuels dont le signal correspond à un pixel de l' image à former ne sont pas isolés électriquement les uns des autres. En particulier un courant formé en fonction de la lumière reçue par une surface se trouvant à l'aplomb d'un premier via 20 peut très bien fuir vers l'un des vias 20 consécutifs voisins. En terme d'image, chacun des pixels dégouline sur les pixels voisins en sorte que les pixels d'une image formée à partir de l'imageur ne sont pas nettement séparés les uns des autres. Une première façon de diminuer ce défaut consiste comme expliqué dans la description de l'art antérieur figurant dans le brevet US 6,114,739 [1], à prévoir des créneaux dans la couche n ou p 14 se trouvant au dessus des vias 20. Ces créneaux apportent une meilleure individualisation de chacune des diodes se trouvant dans l'alignement d'un via 20, et en conséquence une meilleure séparation des pixels d'une image.

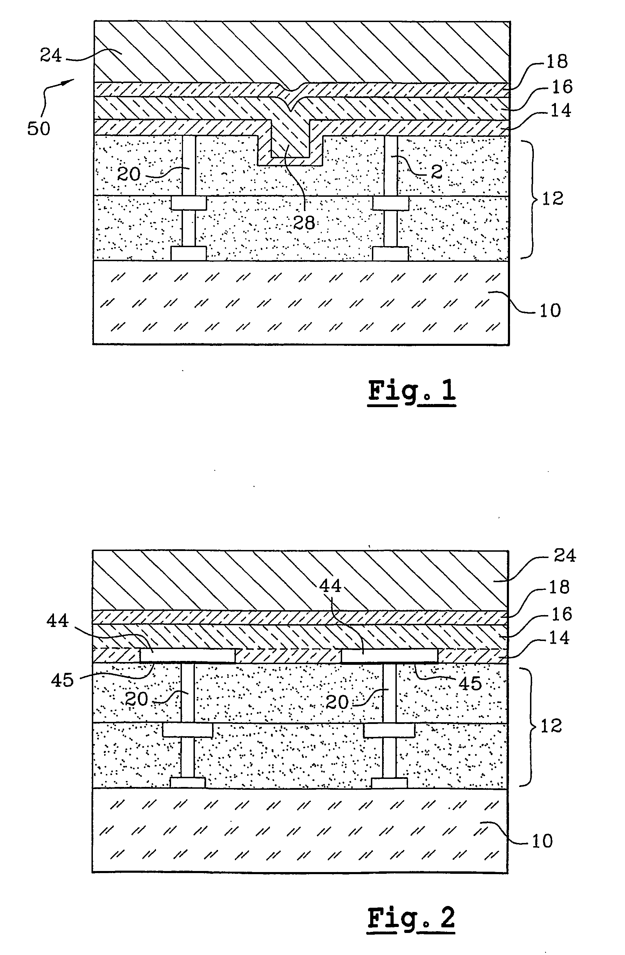

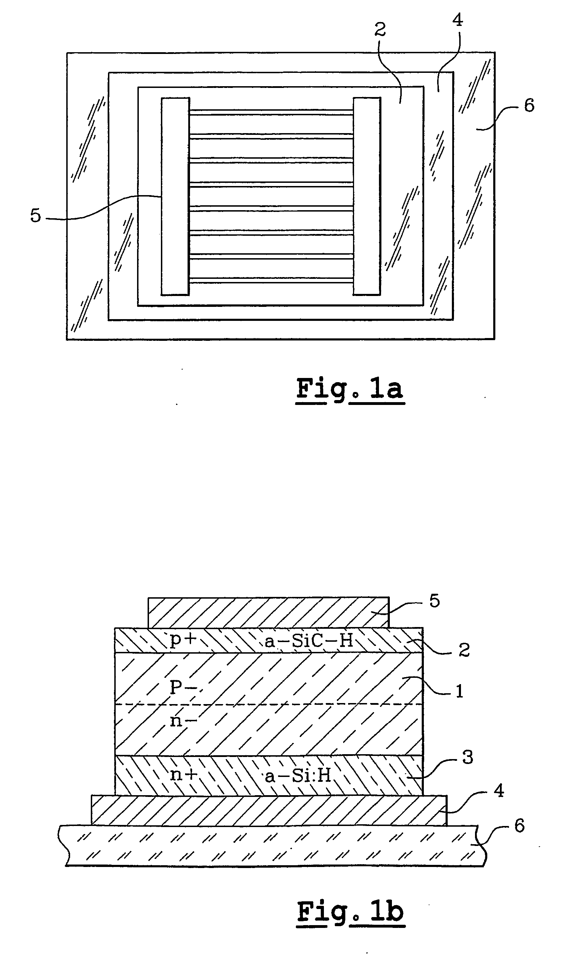

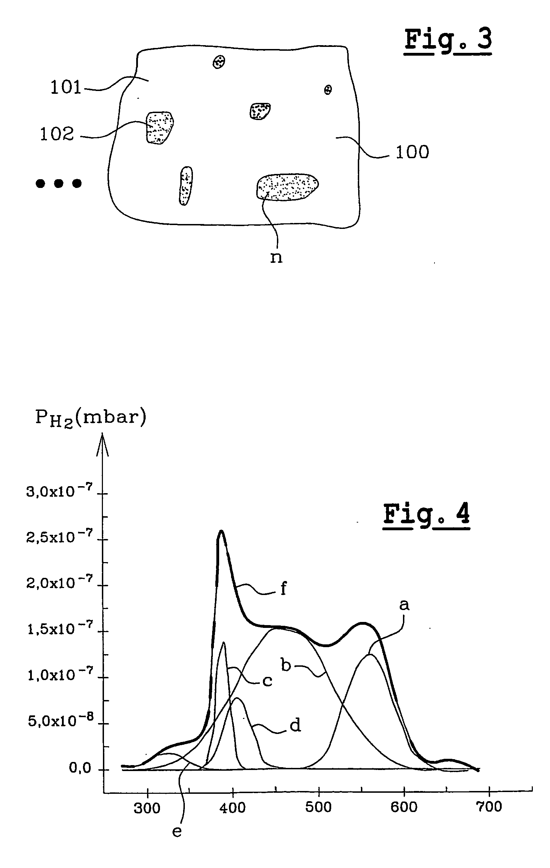

Le brevet US 6,114,739 [1] décrit une amélioration de cet art antérieur destinée à améliorer la séparation. Cette amélioration est décrite en relation avec la figure 2 de ce brevet. Chaque diode détectrice est individualisée d'avantage par le fait qu'elle est équipée de sa propre électrode. La figure 2 des dessins annexés à la présente demande reproduit la figure 2 de ce brevet [1] en conservant pour les éléments ayant même fonction que ceux de la figure 1, les numéros de référence attribués figure 1. Dans le mode de réalisation de la figure 2, la couche n ou p 14, ajoutée en pointillés sur la figure 2 annexée à la présente demande, est gravée après dépôt, de façon à ne laisser subsister que des parties 44 se trouvant au dessus d'un via 20. De plus une couche conductrice de contact est également déposée immédiatement au dessus de la structure d'interconnexion 12. Cette couche de contact est gravée de la même façon que la couche n 14. Une partie 45 non éliminée de cette couche forme avec une partie 44 subsistante de la couche n 14 une électrode d'une diode PIN ou NIP. Ainsi, la couche n 14 étant réticulée, chacune des diodes concourant à la délivrance du signal destiné à former un pixel d'image, se trouve individualisée d'une meilleure façon que dans l'art antérieur.

Le matériau photosensible formant la couche sensible 16 des diodes est un matériau amorphe, par exemple un silicium amorphe ou du carbone amorphe ou du silicium carboné amorphe ou du germanium amorphe ou encore du germanium-silicium amorphe. Il est précisé que cette liste n'est pas exhaustive. Une manière de réaliser la structure réalisée en figure 2 est décrite dans ce brevet en relation avec les figures 3 à 7 de ce brevet qui représentent chacune la structure à différentes étapes de sa réalisation.

L'intérêt d'une structure telle que représentée figure 1 ou 2 est de dissocier la partie détection de la partie adressage, interconnexion, traitement de signal. Ainsi les couches 14, 16, 18, 24 constituent ensemble une brique de détection 50. Le substrat 10 et les circuits de connexion et éventuellement de traitement du signal associés à ce substrat constituent une brique de traitement. Ces deux briques sont interconnectées par la brique d'interconnexion 12. Cette approche modulaire permet de réaliser des imageurs bas coût, compacts, hautement intégrés, c'est à dire comportant un grand nombre de détecteurs individuels par unité de surface, et consommant peu de courant.

Un inconvénient de ce type de structure dans laquelle la matrice active est constituée par un matériau amorphe, est que les performances sont médiocres en terme de dynamique de signal et de tenue des performances au vieillissement. Le silicium amorphe par exemple est connu pour présenter une densité importante de défauts, de l'ordre de 10¹⁶ par cm³. Ces défauts entraînent une limitation de la vitesse possible de fonctionnement en raison du fait qu'ils induisent une rémanence du signal délivré, et donc de l'image. Ces structures sont ainsi impropres à une utilisation pour réaliser des images successives avec une fréquence de répétition élevée. Enfin la structure se dégrade régulièrement pendant les temps d'éclairement, ce qui nuit à la longévité de l'imageur. De plus elle présente un risque de dégradation, voir de destruction, élevé sous forts éclairements.

L'article de référence [2] fait un état des différents détecteurs à UV existants.

Conventionnellement, les détecteurs à semiconducteurs utilisés pour la détection dans l'UV sont des diodes P-I-N en silicium cristallin. Récemment, des matériaux de type GaAlN et SiC ont été utilisés pour réaliser des détecteurs UV insensibles à la lumière visible (visible-blind) et aux rayonnements solaires (solar-blind).

Le document de Afanasev V. P et al. "Photodector structures based on amorphous hydrogenated silicon with nanocrystalline inclusions" HUETTE des Ingenieurs Taschenbuch, 12.12.2001, vol. 68, n°12, pages 949-951, décrit un capteur qui contient du silicium polymorphe.

Le brevet US 5,682,037 [3], déposé en 1996, décrit un exemple de réalisation d'un capteur UV à base de SiC. Dans la description de l'art antérieur faite dans ce brevet, il est tout d'abord indiqué en début de la colonne 2 ce qui suit : "Les photodiodes en silicium cristallin ont une efficacité optimale dans la bande visible et elles ne peuvent être employées pour détecter l'UV qu'après des traitements optiques et mécaniques sophistiqués et coûteux. Elles nécessitent des alimentations basse tension et peuvent être arrangées en réseau de quelques cm de dimension.

Les dispositifs CCD pour l'UV sont des composants à base de silicium cristallin qui nécessitent également un traitement très particulier. Ce sont des détecteurs multicanaux qui sont très sensibles et présentent un rapport signal sur bruit élevé, en particulier s'ils travaillent à basse température. Les électrons photogénérés sont collectés dans une matrice de pixels et sont ensuite lus en séquence. Il est ainsi possible de reconstruire une image bi-dimensionnelle. Il y a au moins trois désavantages majeurs à la détection UV par des dispositifs CCD, à savoir le coût, l'impossibilité d'obtenir des matrices CCD bi-dimensionnelles de grandes dimensions et la nécessité de filtrer la lumière visible ou d'autres radiations lorsque les UV à détecter doivent l'être sur un fond de lumière visible ou d'autres radiations.

L'invention décrite dans le brevet [3] vise à résoudre le problème du filtrage des radiations visibles et infrarouge, de la consommation électrique, de la grande intégration et de plus pour un coût moindre.

L'invention décrite permet l'optimisation de l'épaisseur et du coefficient d'absorption de couche de conducteurs amorphes constituant la jonction, ainsi que la forme géométrique d'une grille métallique servant d'électrode frontale. En plus d'accroître l'efficacité pour qu'elle soit maximale dans l'UV, l'invention permet le réglage de la bande de fonctionnement du détecteur pour la rendre capable de détecter des UV proches ou lointains en fonction de l'application. Il a déjà été démontré qu'en agissant sur les paramètres de dépôt et sur la concentration des impuretés dans l'alliage silicium, l'absorption peut être optimisée pour le visible ou l'infrarouge. Les paramètres physiques à optimiser sont le profil d'absorption, et l'épaisseur du détecteur. Cette optimisation peut être obtenue par le contrôle des paramètres de dépôt, c'est à dire notamment la durée de dépôt et le pourcentage de carbone dans l'alliage.

L'optimisation et la reproductibilité de l'épaisseur des couches sont rendues possibles par le contrôle de la décharge radio fréquence (glow discharge) du dépôt. Le coefficient d'absorption que permet le silicium amorphe hydrogéné, dépend lui des propriétés fondamentales du matériau, telles que la largeur de la bande interdite du semiconducteur et la densité d'états dans la bande. Ceux-ci à leur tour dépendent des paramètres de croissance de la couche d'une manière très compliquée. Une manière simple et reproductible pour faire varier le profil du coefficient d'absorption en fonction de la longueur d'onde est de former des alliages silicium/carbone ou silicium/germanium ayant des pourcentages connus. Ceci est obtenu par l'introduction dans la chambre de dépôt d'un flux contrôlé respectivement de gaz méthane ou de germane. L'alliage de carbone/silicium obtenu est un semiconducteur amorphe ayant une bande interdite de plus grande énergie que le silicium amorphe, ce qui pénalise l'absorption du visible et de l'infrarouge par rapport à l'UV.

Cependant l'alliage a-SiC obtenu ne doit pas contenir un pourcentage trop élevé de carbone par rapport au silicium parce que ses propriétés électroniques en pâtiraient".

En liaison avec les figures 1a et 1b de ce brevet [3], le mode général de réalisation de l'invention du brevet [3] est décrit.

La figure la représente une vue de dessus d'un capteur tel que décrit dans [3] et la figure 1b représente une section transversale dudit capteur.

Le capteur comprend de bas en haut, tel que représenté sur la figure 1b, un substrat 6 par exemple en verre mais, de préférence en quartz de façon à laisser passer les ultra violets. Il comporte ensuite un conducteur transparent 4, et une couche en silicium amorphe hydrogéné dopée n⁺. Le matériau sensible est constitué par deux sous-couches de silicium carboné amorphe hydrogéné (a-SIC : H) l'une dopée n⁻ et l'autre dopée p-, enfin, une couche p⁺ en silicium carboné hydrogéné amorphe 2, recouvert par une grille conductrice 5. Il est indiqué qu'il est préférable de travailler à polarisation nulle entre les électrodes 4 et 5.

La difficulté consiste à conserver les performances électrooptiques sous éclairement car le matériau amorphe a tendance à se dégrader sous éclairement UV. De plus, le rendement quantique externe (capacité à convertir les photons en charges électriques) est faible par la nature du matériau.

Dans le cas des diodes à base de silicium cristallin, la croissance est réalisée à très haute température (supérieure à 400°C), ce qui la rend incompatible avec le dépôt direct sur circuit de lecture CMOS sur substrat Si.

### EXPOSÉ DE L'INVENTION

La présente invention a pour objet un capteur de lumière en particulier pour le domaine des longueurs d'onde du visible, unique ou arrangé en ensemble de capteurs constituant ensemble un imageur. La présente invention vise aussi à permettre la réalisation d'un imageur UV sur un circuit par exemple CMOS par le fait que la couche sensible peut être déposée à température plus basse, par exemple de l'ordre de 300°C ou moins.

Un capteur de lumière éventuellement arrangé en ensemble de capteurs constituant ensemble un imageur, selon la présente invention présente en outre les avantages des systèmes modulaires décrits plus haut :
une réponse temporelle améliorée, c'est à dire des temps de montée et descente de la valeur du signal délivré en fonction des variations de l'éclairement suivant au plus près ces variations mêmes lorsque ces variations sont rapides,
une faible rémanence, et donc autorisant la production d'images successives avec une grande fréquence de répétition,
une meilleure tenue au vieillissement, et une résistance accrue aux forts éclairements.

De plus les imageurs réalisés avec ces capteurs s'accommodent d'une grande intégration, c'est à dire qu'ils fonctionnent correctement même avec un grand nombre de pixels par unité de surface.

L'invention propose en particulier d'augmenter fortement la sensibilité pour les longueurs d'onde comprises entre 10 et 400 nm, tout en réduisant la sensibilité parasite vers 700 nm.

Enfin, avec un imageur selon l'invention, il est possible d'utiliser une plus grande gamme de circuits de lecture, incluant en particulier des circuits de lecture à commutation de polarisation entre chaque lecture. Cette possibilité devient ouverte en raison de la grande dynamique temporelle du matériau photosensible.

A toutes ces fins, l'invention est relative à un capteur unique ou un ensemble de capteurs de lumière visible constitué en imageur chaque capteur délivrant un signal correspondant à un pixel de l'image, et ayant,
une brique de détection ayant une zone de détection comportant un matériau photosensible,
une brique d'adressage et éventuellement de traitement de signaux en provenance du ou des capteurs, cette brique ayant notamment un circuit d'adressage et;
une brique d'interconnexion située entre la brique de détection et la brique d'adressage, cette brique ayant des plots de raccordement raccordant des pixels de l'imageur au circuit d'adressage, en sorte que les signaux provenant des pixels soient individualisés,
caractérisé en ce que le matériau photosensible de la brique de détection contient an moins une couche en silicium polymorphe et en ce que des électrodes sont formées au-dessus de plots, ces électrodes ayant une surface inférieure couplée électriquement à un plot, et une surface supérieure de l'électrode ayant une dimension surfacique plus grande que le surface inférieure au contact du plot.

L'invention est relative aussi à un capteur ou un ensemble de capteurs pour rayonnement ultra violet, chaque capteur délivrant un signal correspondant à un pixel de l'image, et ayant,
une brique de détection ayant une zone de détection comportant un matériau photosensible,
une brique d'adressage et éventuellement de traitement de signaux en provenance des capteurs et,
une brique d'interconnexion située entre la brique de détection et la brique d'adressage
caractérisé en ce que le matériau photosensible de la brique de détection contient du silicium polymorphe ayant une épaisseur inférieure à 0,4 µm et de préférence comprise entre 0, 01 et 0,05 µm, et en ce que des électrodes sont formées au-dessus de plots, ces électrodes ayant une surface inférieure couplée électriquement à un plot, et une surface supérieure, la surface supérieure de l'électrode ayant une dimension surfacique plus grande que la surface inférieure au contact du plot.

La sélectivité de la bande de fréquence sensible pourra être déterminée par le choix d'une température de dépôt de la couche en silicium polymorphe comprise entre 150°C et 250°C, une pression comprise entre 1300 et 1800 mTorr.

Le silicium polymorphe présente une faible densité d'états de défauts en milieu de bande interdite et un produit mobilité des porteurs par durée de vie desdits porteurs élevée. On pourra à ce sujet se reporter à l'article de référence [4] dont la référence figure en fin de document. De ce fait la dynamique temporelle, c'est à dire la capacité d'un détecteur ainsi réalisé à suivre les variations temporelles d'un éclairement est améliorée aux grandes vitesses de variation d'éclairement ou de polarisation électrique. La rémanence est diminuée et donc il devient possible de réaliser des images successives avec une grande fréquence de répétition. De plus il a été constaté que les performances d'un imageur réalisé avec une structure selon l'invention présentait une meilleure stabilité dans le temps, notamment sous forts. éclairements.

De préférence la brigue d'interconnexion est constituée par des plots noyés dans de l'isolant.

De préférence les plots d'interconnexion sont en aluminium ou en cuivre ou en tungstène.

De préférence le matériau isolant noyant les plots, est constitué par un empilement de couches diélectriques formant des miroirs de Bragg.

De préférence, la surface supérieure des électrodes présente une forme de cuvette.

De préférence, une partie inférieure de chaque électrode est noyée dans une couche d'isolant, une partie supérieure de cette électrode venant au-dessus de ladite couche d'isolant.

De préférence, la couche d'isolant entourant une partie inférieure des électrodes est constituée d'un empilement de couches formant miroirs de Bragg.

De préférence, les électrodes sont en aluminium, ou en cuivre, ou en tungstène, ou en titane, ou en nitrure de titane, ou en chrome, ou en un semi-conducteur dopé, ou en un conducteur organique, ou en un oxyde conducteur, ou enfin encore en un empilement composite des matériaux cités ci-dessus.

De préférence, la couche de matériau polymorphe est placée au-dessus de la couche comportant l'isolant et les électrodes.

De préférence, au moins une couche supérieure en silicium présente une partie inférieure contenant du carbone et une partie supérieure contenant du bore.

De préférence, l'épaisseur de la couche en matériau polymorphe d'un capteur ou ensemble de capteur pour lumière visible est comprise entre 0, 5 et 2 µm.

De préférence, la zone de détection comportant le silicium polymorphe est une zone intrinsèque d'une diode PIN ou NIP.

On décrira aussi un procédé de réalisation d'un ensemble de photodétecteurs selon l'un des modes de réalisation de cet ensemble, caractérisé en ce que :
après réalisation d'un substrat comportant notamment un circuit d'adressage, et éventuellement des circuits de traitement de signaux,
on dépose une ou plusieurs couches de matériaux isolants,
on grave ladite couche de façon à former des trous dans cette couche,
on comble des trous avec un matériau conducteur constituant ainsi des plots d'interconnexion (5, 5'),
on effectue éventuellement un polissage mécano-chimique,
on dépose une ou plusieurs sous-couches de matériau isolant,
on grave ladite sous-couche de matériau isolant au-dessus de plots,
on dépose une couche au-dessus de la couche isolante gravée, formant ainsi une couche non plane de matériau conducteur, des cuvettes apparaissant au-dessus des plots,
on grave la couche de matériau conducteur qui vient d'être déposée, de façon à former des électrodes séparées les unes des autres,
on dépose une couche de matériau polymorphe non intentionnellement dopée,
on dépose une couche dopée
on dépose enfin une couche d'un matériau conducteur formant électrode supérieure.

De préférence, la température de dépôt du matériau polymorphe est comprise entre 175°C et 250°C et la pression de dépôt est comprise entre 1300 et 1800 mTorr.

De préférence, le dépôt du matériau polymorphe est suivi par un dépôt d'une couche contenant du carbone au moins dans sa partie inférieure.

### BRÈVE DESCRIPTION DES DESSINS

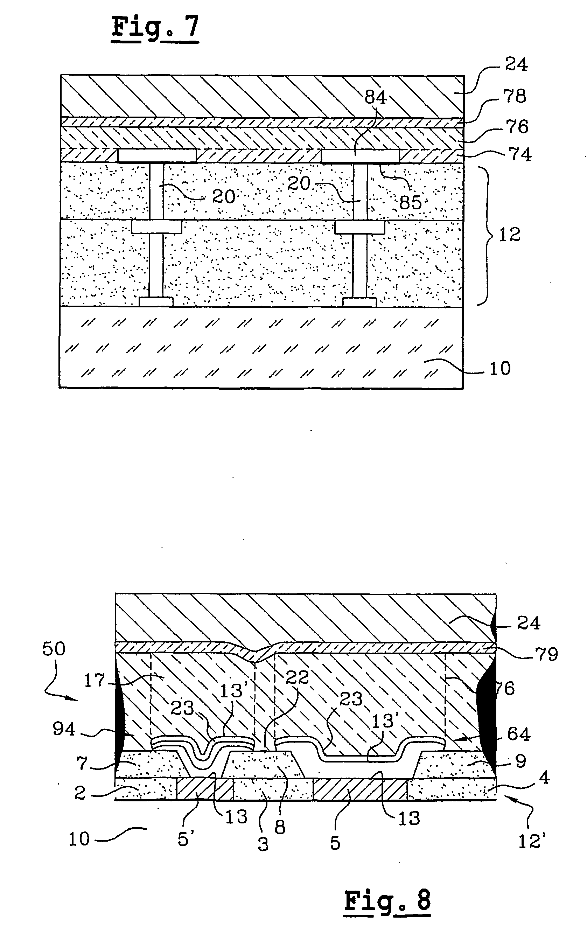

L'invention sera maintenant décrite à l'aide des dessins annexés dans lesquels :
- la figure 1, déjà décrite, montre une coupe transversale d'une structure d'un photodétecteur selon l'art antérieur ;
- la figure 1a, déjà décrite, montre une vue de dessus d'une structure d'un photodétecteur selon l'art antérieur ;
- la figure 1b, déjà décrite, montre une coupe transversale dudit photodétecteur de l'art antérieur représenté figure 1a ;
- la figure 2, déjà décrite, montre une coupe transversale d'un autre photodétecteur de l'art antérieur ;
- la figure 3 est une représentation schématique de la structure d'un silicium polymorphe ;
- les figures 4 à 6 montrent différentes façons de caractériser un silicium polymorphe ;

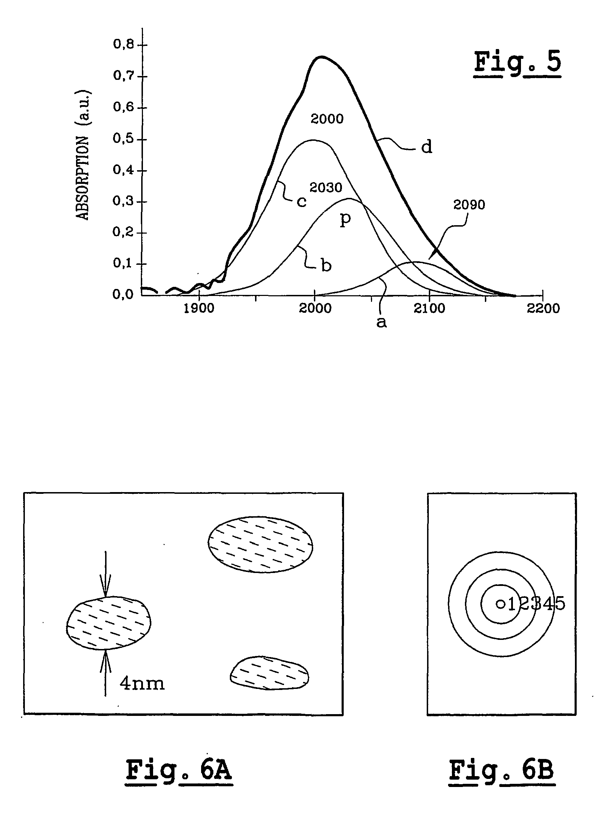

- la figure 4 représente le spectre d'hexodiffusion du silicium polymorphe ;
- la figure 5 représente des courbes du spectre d'absorption infrarouge ;
- les figures 6A et 6B représentent respectivement une image microscopique électronique haute résolution (HRTEM) d'un matériau polymorphe et sa transformée de Fourier spatiale équivalente à un spectre de diffraction électronique;
- la-figure 7 représente un mode de réalisation de l'invention qui correspond à la figures 2, et dans lequel le matériau photosensible est du silicium polymorphe;
- la figure 8 représente un mode particulier de réalisation de l'invention selon deux variantes ;

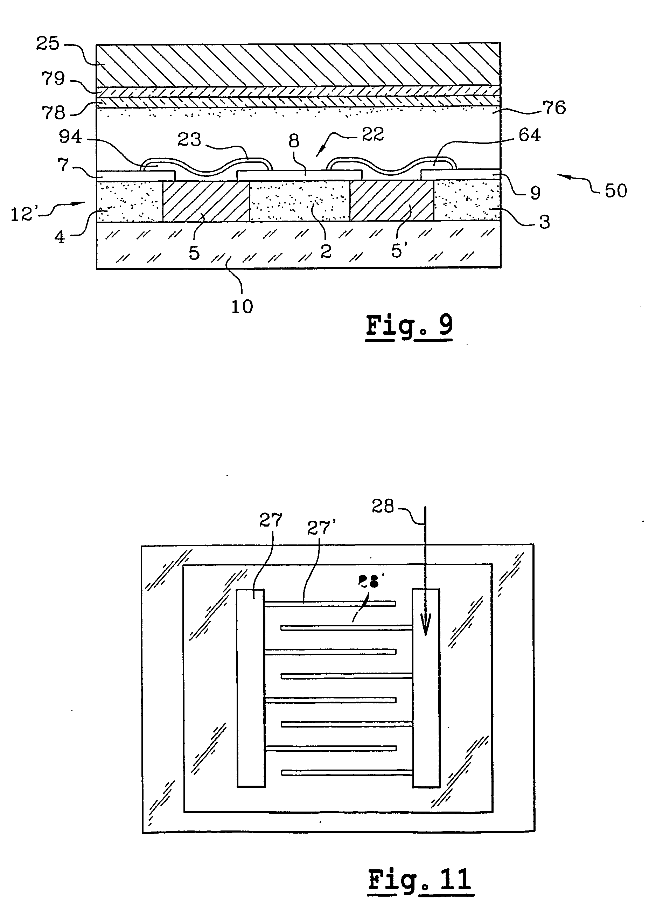

- la figure 9 représente des courbes du courant d'obscurité résiduel divisé par le courant photonique en fonction de la puissance optique, d'une part, pour un silicium amorphe et, d'autre part, pour un silicium polymorphe.

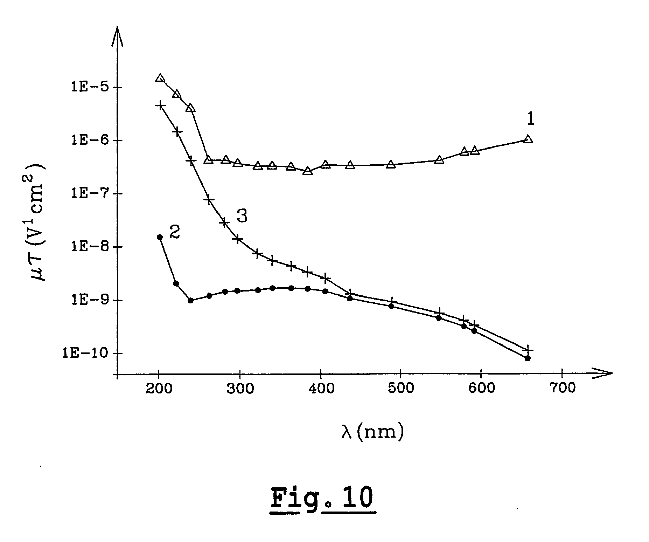

La figure 10 représente dans un repère orthonormé des valeurs de densité surfacique de courant de fuite pour différentes tailles de pixels.

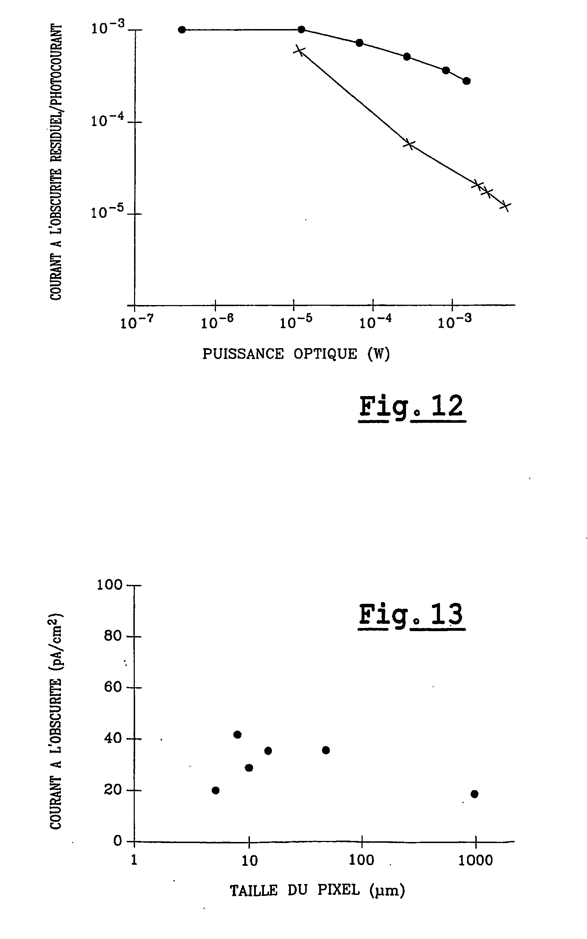

- la figure 11 représente un mode de réalisation de l'invention dans lequel le matériau photosensible est du silicium polymorphe ;
- la figure 12 représente une vue de dessus d'un détecteur selon l'invention dans lequel l'électrode supérieure est constituée de deux peignes à doigts interdigités ;
- la figure 13 représente dans un repère orthonormé des valeurs de densité surfacique de courant de fuite pour différentes tailles de pixels.

### EXPOSÉ DÉTAILLÉ DE MODES DE RÉALISATION PARTICULIERS

Comme il a été expliqué plus haut, par rapport à l'art antérieur, l'invention consiste à remplacer un matériau amorphe constituant la couche active par du silicium polymorphe.

Il sera tout d'abord indiqué comment il est possible à l'examen de reconnaître un silicium polymorphe d'un silicium amorphe. La structure d'un silicium polymorphe est schématisée dans la figure 3. Le silicium polymorphe comporte une matrice 100 dans laquelle des agrégats et nanocristaux 101, 102, etc. n, n étant supérieur à 102, représentés par des tâches noires de forme et de grosseur variable, sont incorporés. Des mesures de microscopie permettent de montrer que la matrice contenant les nanocristaux présente un ordre à moyenne distance, entre le deuxième et le sixième voisin atomique. La nanostructure du silicium polymorphe est aussi caractérisée notamment par l'absorption infrarouge, la microscopie, la spectroscopie Raman. Elle peut être aussi caractérisée par un spectre d'hexodiffusion de l'hydrogène clairement distinct de celui du silicium amorphe.

Des différences que l'on peut observer entre du silicium amorphe et du silicium polymorphe sont données par exemple dans les figures 4 à 6.

La figure 4, représente le spectre d'exodiffusion du silicium polymorphe. Ce spectre est défini par des courbes représentant la pression partielle de l'hydrogène en millibars par rapport à la température du matériau en °C. La manière de réaliser ces spectres est bien connue dans l'art. Des explications permettant de comprendre grossièrement de quoi il s'agit sont données ci-après pour faciliter la compréhension. La pression partielle d'hydrogène sortant du matériau est mesurée en fonction de la température de recuit. L'hydrogène est lié au matériau selon différentes configurations atomiques qui présentent chacune une énergie de liaison différente. A chaque configuration de liaison correspond donc une courbe de libération de l'hydrogène en fonction de la température, se présentant sous la forme d'une courbe en cloche présentant un pic. Le spectre du silicium amorphe a la forme représentée par la courbe a. Il ne présente qu'un pic entre 500 et 600°C, associé à l'hydrogène uniformément distribué dans la matrice amorphe. Les courbes b, c, d et e représentent respectivement des courbes de libération d'hydrogène correspondant chacune à une configuration spécifique de liaison de l'hydrogène. Lorsqu'on fait la mesure d'exodiffusion du silicium polymorphe, on obtient la courbe f qui correspond à la résultante des différentes configurations de liaison de l'hydrogène qui existent dans le matériau polymorphe. La forme de la courbe f caractérise ainsi l'incorporation d'hydrogène à la surface d'agrégats et nanocristaux et dans la matrice présentant un ordre à moyenne distance.

Une autre manière de reconnaître du silicium polymorphe par rapport à du silicium amorphe sera maintenant décrite en relation avec la figure 5 qui représente le spectre d'absorption infrarouge dans la zone dont le nombre d'onde exprimé en cm⁻¹ est compris entre 1900 et 2200. L'absorption, en unité arbitraire, est portée en ordonnée et le nombre d'onde est porté en abscisse. La courbe d représente le résultat expérimental de la mesure d'absorption. Les courbes a, b, c représentent respectivement, les courbes obtenues par un calcul de déconvolution que l'on peut faire puisque les différents pics élémentaires d'absorption sont connus. Cette déconvolution du spectre expérimental met en évidence pour le silicium polymorphe la présence d'un pic supplémentaire p entre 2030 et 2050 cm⁻¹. Ce pic correspond à la courbe b. La position du pic dépend des conditions d'élaboration du silicium polymorphe.

Enfin, en figure 6A et 6B on a représenté un schéma d'une image haute résolution obtenue par microscopie électronique en transmission (HRTEM) du matériau polymorphe dans laquelle on peut distinguer des cristaux de quelques nanomètres de diamètre. Ces nanocristaux apparaissent sur la photo comme des régions dans lesquelles on distingue des lignes parallèles entre elles. Ces nanocristaux ont été représentés figure 6A par des régions à l'intérieur desquelles apparaissent des lignes pointillées parallèles entre elles. La transformée de Fourier spatiale de l'image de la zone amorphe permet de mettre en évidence un ordre à moyenne distance. Cette transformée est schématisée figure 6B. L'ordre à moyenne distance se matérialise par la présence d'anneaux entourant un point commun. Pour du silicium amorphe on peut distinguer deux anneaux et éventuellement de façon très floue un troisième anneau. Pour du silicium polymorphe on arrive à distinguer 4 anneaux matérialisés figure 6B par la présence d'anneaux blancs et noirs. De plus les anneaux ont une intensité plus grande et une largeur plus fine que dans le cas du silicium amorphe. On pourra se reporter à ce sujet à l'article de référence [5] référencé en fin de description.

Un premier exemple de réalisation d'un ensemble de photodétecteurs selon l'invention sera maintenant décrit en référence à la figure 7. Cette figure reprend exactement la figures 2 de l'art antérieur. Dans cette figure les éléments ayant le même numéro de référence que ceux de la figure 2 indiquent des éléments ayant même fonction , et qui peuvent être réalisés de la même façon. En ce qui concerne la figure 7 qui reprend le mode de réalisation de la figure 2, la seule différence est que le matériau amorphe constituant la couches, i 16 est remplacée maintenant par une couche de silicium polymorphe. La couche n 14 a été découpée pour ne laisser subsister que des électrodes 84. Les couches i 16 et p 18 sont référencées 76 et 78 respectivement. La couche de contact 45 est remplacée par une couche de contact 85.

Un mode préféré de réalisation sera maintenant décrit en liaison avec la figure 8.

Ce mode de réalisation diffère des modes de réalisation de l'art antérieur, en particulier celui décrit en liaison avec la figure 2, d'une part, comme dans le cas général par l'utilisation d'un matériau polymorphe pour former la couche active, mais aussi par la forme de réalisation de la couche d'interconnexion représentée en 12', figure 8 et par la forme des électrodes dont deux dessins sont représentés figure 8 sous les références 94 et 64.

Dans les modes de réalisation décrit en relation avec les figure 8 ou 9, le substrat 10 peut avoir toute configuration déjà connue de l'art antérieur. Ce substrat ne sera donc pas décrit.

Un mode de réalisation de la couche 12' formant la brique 12' d'interconnexion selon ce mode de réalisation de l'invention ainsi que des procédés de réalisation de cette brique au dessus du substrat 10 seront maintenant décrits.

Cette couche comporte des plots conducteurs 5, 5' noyés dans une matière isolante comblant complètement des espaces latéraux 2, 3, 4 entre les plots 5, 5'.

Deux formes de réalisation des plots d'interconnexion ont été représentées en 5 et 5' figure 8. Ces plots sont formés au-dessus du substrat 10. Dans l'exemple représenté figure 8, les plots 5 et 5' sont cylindriques. Les plots pourraient également être cubiques ou coniques avec leur base la plus petite située par exemple du côté du substrat, ou avec des bases ayant des surfaces différentes, par exemple, hexagonales. Ces plots sont en nombre égal ou supérieur au nombre de pixels de l'imageur que l'on veut former. On peut se reporter à ce sujet au brevet de référence [6] dans lequel il est décrit, en liaison avec la figure 7 de ce brevet, un imageur dans lequel des liaisons d'interconnexion 56 assurent d'autres fonctions que des fonctions de raccordement d'une diode à un circuit d'adressage. Les plots 5, 5' du mode de réalisation de l'invention décrits en liaison avec la figure 8 annexée à la présente demande, sont formés en aluminium.

Les plots 5, 5' peuvent aussi être transparents, mono ou multicouche, de tailles et de formes géométriques quelconques. Leur fonction est de transmettre l'information électrique entre le substrat 10 et la diode. Cela requiert notamment une bonne adhérence mécanique entre un plot d'interconnexion 5 et l'électrode inférieure 64, 94.

Des méthodes pour former les plots d'interconnexion 5 sont bien connues dans le domaine de la microélectronique et de l'optoélectronique. Les plots 5 peuvent être réalisés, par exemple, en déposant une couche conductrice continue, en gravant des tranchées autour des plots, et en remplissant les tranchées avec un matériau isolant électriquement.

Naturellement la couche 12' peut aussi et de préférence être réalisée en déposant d'abord le matériau isolant puis en gravant des trous à l'emplacement des plots 5 5'. Les trous sont alors remplis par le ou les matériau(x) conducteurs constituant les plots 5, 5'.

Dans les deux procédés de réalisation qui viennent d'être décrits, on arrive à la forme représentée par la couche 12' sur la figure 8, où de la matière isolante se trouve dans les espaces 2, 3, 4 entre plots 5, 5'. Un polissage mécano-chimique additionnel éventuel permet d'obtenir ensuite une surface plane.

La forme des plots 5 résulte pour partie de la géométrie de la gravure et pour partie du mode de gravure.

Il est également possible d'utiliser des techniques de lift off ou tout autre méthode connue pour obtenir ce genre de structure.

Les matériaux des plots 5 ou 5' sont généralement de type métallique, comme l'aluminium, le cuivre ou le tungstène, mais il est également possible d'utiliser d'autres matériaux conducteurs comme le titane, le nitrure de titane, un oxyde transparent conducteur, un matériau organique conducteur ou tout autre matériau assurant la conduction électrique sans dégrader l'adhérence mécanique entre le plot et l'électrode qui se trouve au-dessus. Une autre caractéristique importante des plots 5, 5' est de ne pas trop se dégrader dans le temps par oxydation ou électro-migration ou sous l'effet de la température. Le plot 5 utilisé doit notamment supporter sans se dégrader la température de dépôt des matériaux constituant la brique de détection 50, typiquement une température de 300°C pendant au moins une heure.

Il sera vu plus loin que le dépôt du matériau photosensible suppose que le substrat 10 muni de la couche 12' puisse être soumis à cette température pendant au moins une heure. La constante de diffusion du matériau constituant un plot 5 doit être suffisamment faible pour ne pas compromettre l'isolation de deux pixels adjacents à l'issue d'un recuit de 300°C pendant une heure. De même, les matériaux isolants utilisés dans les espaces 2, 3, 4, entre plots et dans des espaces 7, 8, 9 entre électrodes dont il sera parlé plus loin, doivent conserver leurs propriétés diélectriques à l'issu du même traitement. Ces matériaux seront choisis de préférence dans la famille des diélectriques utilisés en micro-électronique, par exemple, en oxyde de silicium ou nitrure de silicium, mais pas exclusivement.

Il est également possible au besoin d'utiliser pour la matière comblant les espaces latéraux entre plots et/ou entre électrodes un empilement de couches diélectriques afin de réaliser des miroirs de Bragg pour empêcher la lumière d'atteindre le substrat. Tout agencement composite de matériau, de forme ou géométrie quelconque pourra être utilisé à condition de satisfaire les exigences d'isolation électrique, de stabilité mécanique et de tenue dans le temps et en température.

La forme des électrodes 64, 94 et leur procédé de réalisation seront maintenant décrits.

Il doit être compris que dans un même imageur, les électrodes peuvent avoir toutes la même forme mais pas nécessairement.

Les électrodes 94 et 64 ont de préférence une forme telle que la surface 13 de leurs zones de contact avec un plot 5 est inférieure à la surface opposée 13', qui est en contact avec la couche i 76. La surface de contact 13 entre une électrode 94, 64 et le plot de contact 5 peut être inférieure à la surface d'un plot 5 comme représenté pour l'électrode 94 sur la figure 8 ou au contraire égale comme représenté en 64. Dans le cas représenté en 64, la surface du plot 5' est inférieure à la surface inférieure 13 de l'électrode 64. La surface opposée 13' à la surface de contact 13 de l'électrode 94 a une forme donnant une plus grande surface d'électrode dans un espace occupé identique. On veut dire par là que la surface supérieure 13 de l'électrode 94 est supérieure à la surface d'une section droite 17 du pixel. La section droite de ladite surface du pixel est représentée en pointillés sur la figure 8. Le caractère concave de l'électrode 94 permet de donner à cette électrode une plus grande surface. De même, dans l'exemple représenté en 64, la surface supérieure 13' de l'électrode a une surface plus grande que la surface occupée par une section droite du pixel. De la matière isolante comble complètement les espaces 7, 8, 9 qui se trouvent en position latérale autour d'une partie inférieure des électrodes.

La matière isolante qui comble les régions 2, 3, 4 entre plots 5, 5', et 7, et 8 et 9 entre électrodes 94, 64 permet d'éviter les fuites de courant entre plots 5, 5' et a fortiori les courts circuits. Les électrodes 94, 64 ont pour but d'assurer le contact électrique entre la région i en silicium polymorphe 76 et les plots 5.

Les électrodes 94, 64 sont également obtenues par des procédés standards de la micro-électronique, comme par exemple le dépôt d'une couche diélectrique continue, la gravure de trous, cette gravure laissant subsister les espaces latéraux 7, 8 et 9 entre électrodes. On procède ensuite au dépôt de la ou des couches conductrices formant la matière des électrodes.

La forme en cuvette des électrode résulte alors naturellement de la présence des trous dans la couche isolante gravée. Une gravure de la couche conductrice de zones 22 entre électrodes 94, 64 permet une séparation des électrodes 94, 64 entre elles.

Les électrodes pourront aussi et de préférence être constituées à partir d'un empilement de couches comportant notamment comme représenté figure 8 ou 9 entre la couche 76 et l'électrode 64, 94 une couche 23 en TiN ou Ti jouant le rôle de barrière de diffusion. L'électrode 94 ou 64 pourra également se terminer par une couche de silicium dopé, ou une couche superficielle d'alliage Si_{1-(x+y)}GeₓC_{y} (x compris entre 0 et 1 ; y compris entre 0 et 1) dopé de type n ou p ou par une couche de semi-conducteur dopé par des ions par exemple métalliques mais pas exclusivement. Les électrodes 94 et 64 pourront aussi être encapsulées par une couche de conducteurs organiques comme par exemple un polymère organique.

Les matériaux constituant les électrodes 94 et 64 sont choisis parmi les matériaux conducteurs, à condition de satisfaire aux exigences de tenue mécanique, chimique, thermique et de stabilité dans le temps, compatibles avec les matériaux adjacents et le bilan thermique global du procédé de fabrication de l'imageur. Les matériaux constituant les électrodes 64, 94 seront choisis notamment parmi l'aluminium, le cuivre, le tungstène, le titane, le nitrure de titane, un semi-conducteur dopé compatible avec les matériaux voisins, un conducteur organique, un oxyde conducteur, ou tout empilement ou agencement composite de tels matériaux.

La région 76, qui sera maintenant décrite, est la partie active de l'élément photosensible élémentaire, elle comporte au moins une région en silicium polymorphe. La région 76 est, par exemple, dans le cas où les diodes détectrices sont des diodes PIN ou NIP, une zone i.

La région 76 comporte préférentiellement une couche polymorphe non intentionnellement dopée avoisinant une région comportant du silicium et éventuellement un dopant et éventuellement du carbone. La région 76 pourra par exemple contenir une zone de gain, (on peut se reporter à ce sujet à l'article de référence [7]) des zones dopées de nature et de géométrie diverses, ou tout agencement utile de matériau et de géométrie, à condition de contenir au minimum une région comportant du silicium polymorphe

Dans le mode de réalisation, représenté sur la figure 8,une couche 79 en silicium est présente au sommet de la couche 76 immédiatement au dessous de la couche 24 formant électrode. Cette couche 79 constitue dans sa partie supérieure la zone p de la diode grâce à un dopage du silicium par le bore. Dans sa partie inférieure, elle peut avantageusement contenir du carbone. On améliore ainsi la qualité de l'interface entre les couches i et p. Cette couche 79 peut aussi remplacer la couche p 78, venant au dessus de la couche i représenté figure 7.

De préférence pour un capteur de lumière visible, la couche sensible i 76 en matériau polymorphe aura une épaisseur comprise entre 0,5 et 2 µm.

La région 24 représentée figure 8 a pour but, comme dans l'art antérieur, de constituer une électrode pour collecter les charges, tout en laissant passer la lumière visible afin qu'elle atteigne la région 76. Elle sera de préférence réalisée en ITO (oxyde d'indium et d'étain) ou à base de tout oxyde transparent conducteur ou autre matériau transparent et conducteur, incluant les polymères organiques conducteurs.

De façon surprenante, il a été constaté que l'utilisation de silicium polymorphe comme matériau sensible conduisait à des imageurs présentant une rémanence diminuée malgré la présence dans le matériau, d'un grand nombre d'interfaces entre la matrice et les nanocristaux et agrégats.

Dans le mode de réalisation, représenté sur la figure 9, des couches 78, 79 en silicium sont présentes au sommet de la couche 76 immédiatement au dessous d'une couche 25 formant électrode dont il sera parlé plus loin.

La couche 79 constitue la zone p de la diode grâce à un dopage de silicium par le bore. La couche 78 peut avantageusement contenir du carbone. On améliore ainsi la qualité du contact.

De préférence pour un imageur ultra violet, la couche sensible i 76 en matériau polymorphe aura une épaisseur inférieure à 0,4µm et de préférence voisine de 0.05 µm.

Le dépôt de la couche 76 en silicium polymorphe sera maintenant décrit.

Le silicium polymorphe est obtenu par des procédés PECVD (Plasma Enhanced Chemical Vapor Deposition) à basse température entre 100 et 400°C, à partir de la dissociation du silane pur ou mélangé à d'autres gaz (He, H₂, Ar), dans des conditions proches de la formation de poudre. En général le silicium polymorphe est obtenu en ajustant les paramètres technologiques du plasma à partir duquel la déposition est faite : pression, dilution et puissance de la radio fréquence, qui aboutissent à la formation d'agrégats et nanocristaux dans le plasma. On pourra se reporter à ce sujet à l'article de référencé [5]. Le matériau polymorphe est donc formé à partir de l'incorporation des agrégats et nanocristaux qui confèrent au silicium polymorphe ses propriétés spécifiques, particulièrement adaptées à la détection. En effet, malgré la microstructure, la présence d'agrégats et nanocristaux induit une faible densité d'état de défauts et un fort produit mu tau (mobilité des porteurs par durée de vie des porteurs) typiquement 100 fois plus grand que dans le silicium amorphe.

La figure 10 représente, en fonction de la longueur d'onde, le produit mu tau obtenu sur des structures métal-(pm-Si : H)-métal. La courbe 1 est la réponse d'un échantillon épais de matériau polymorphe (de l'ordre de 1,5 µm) qui présente une faible sélectivité (environ 10). Afin d'augmenter le rapport de sélectivité UV par rapport au visible, l'épaisseur de la couche polymorphe a été diminuée. La courbe 2 montre là réponse d'une couche mince de polymorphe, de l'ordre de 200 Å. Cette courbe montre un produit mu tau sensiblement constant entre 250 et 500 nanomètres de longueur d'onde. La sélectivité en longueur d'onde de cette couche sera donc faible. La courbe 3 est la réponse d'une couche mince de silicium polymorphe d'épaisseur identique à celle de la courbe 2 mais qui se différencie de cette dernière par les conditions de dépôt. Cette courbe montre une décroissance forte du produit mu tau lorsqu'on passe des longueurs d'onde de 200 nanomètres à 400 nanomètres, ce qui permet d'obtenir une sélectivité entre les différentes longueurs d'onde favorisant les longueurs d'onde de l'ultra violet. On obtient une sélectivité de l'ordre de 38000.

L'électrode supérieure 25 représentée figure 9 pour l'imageur ultraviolet peut, comme dans le document de référence [2], avoir la forme d'une grille métallique.

Elle peut aussi, comme représenté figure 11, se présenter sous la forme de deux peignes 27, 28 dont les dents 27', 28' respectivement sont interdigités. Les deux peignes sont isolés l'un de l'autre en sorte qu'ils peuvent être portés à des potentiels différents. Enfin, l'électrode 25 peut aussi se présenter sous la forme d'une couche mince d'argent. L'article de référence [6], et notamment sa figure 3, montre des réponse spectrales différentes en fonction de l'épaisseur de la couche d'argent constituant une électrode supérieure. La couche d'argent permet d'obtenir un pic pour les longueurs d'onde autour de 320 nanomètres, la largeur de bande à partir de ce pic allant en diminuant lorsque l'épaisseur de la couche d'argent varie par exemple entre 10 nanomètres et 130 nanomètres.

Il convient de préciser que dans le mode de réalisation de la brique de détection 50 qui vient d'être décrit, il est formé une diode PIN par pixel. L'un des contacts de la diode PIN est constitué par la surface supérieure du plot 5, 5'. Les électrodes 64, 94 peuvent être réalisées dans un semi conducteur dopé n par exemple dans du silicium carboné hydrogéné amorphe a-SiC : H dopé à l'arsenic. La couche intrinsèque est formée par du silicium hydrogéné pm-Si :H. La couche p 79 est de nouveau en silicium amorphe hydrogéné a-Si :H dopé au bore et éventuellement au carbone.

Des variantes de réalisation de la brique de détection 50 seront maintenant décrites. Ces variantes concernent de façon indépendante l'une de l'autre des variations sur la couche 76 et sur l'électrode 25.

Au lieu d'être dans l'ordre n-i-p comme décrit ci-dessus l'empilement de couches formant chacune des diodes au dessus des plots 5, 5' peut aussi être p-i-n

Il n'est pas obligatoire d'avoir des électrodes 64, 94 au dessus de chaque plot 5, 5'. Une barrière peut être obtenue en déposant directement une couche intrinsèque i, non intentionnellement dopée, directement au dessus de la brique d'interconnexion 12'. Dans ce cas au moins la couche supérieure des plots 5, 5' sera un métal, par exemple du platine, du tungstène ou du palladium. Une couche n ou une couche p pourra se trouver au dessus de la couche i.

L'empilement de couches au dessus des plots 5,5' peut aussi comprendre une couche p ou une couche n, puis la couche i, cette couche i se trouvant directement au contact de l'électrode 25, qui dans ce cas est métallique par exemple du platine, du tungstène ou du palladium.

Dans tous les cas qui viennent d'être décrits ci-dessus la couche i ou au moins une sous couche de cette couche i est en silicium polymorphe.

De façon surprenante, il a été constaté que l'utilisation de silicium polymorphe comme matériau sensible conduisait à des imageurs présentant une rémanence diminuée et une sensibilité très élevée.

La figure 12 met en évidence le gain en performance obtenu sur un dispositif selon l'invention. Cette figure représente deux courbes a et b. Chacune des courbes représente le courant d'obscurité subsistant 0,2 secondes après l'interruption de l'incidence d'une lumière dont la puissance optique est portée en abscisse. La courbe a représente ce courant d'obscurité pour un silicium amorphe hydrogéné, et la courbe b montre ce même courant pour une couche utilisant un silicium polymorphe selon l'invention. On constate que la fraction de courant à l'obscurité après extinction de la lumière est sensiblement plus faible avec le silicium polymorphe qu'avec le silicium amorphe. Il s'ensuit que les effets de rémanence d'image obtenus avec un imageur selon l'invention sont sensiblement réduits en utilisant un pixel à base de matériau polymorphe.

Il a été constaté de plus que le matériau polymorphe permet d'augmenter notablement la stabilité dans le temps des imageurs notamment sous éclairement. Le matériau polymorphe permet d'atteindre des courants de fuite à l'obscurité de l'ordre de 10⁻¹¹ pA/cm² , avec une excellente réponse spectrale. Les rendements quantiques externes mesurés atteignent plus de 30 % au voisinage de longueur d'onde incidente de 300 nm, et la largeur de bande interdite du silicium polymorphe est plus élevée que celle du silicium amorphe, donc le photocourant obtenu au voisinage de 700 nm, c'est-à-dire dans le rouge et le proche infrarouge est plus faible, ce qui présente l'avantage de ne plus avoir besoin de filtres colorés éliminant le rayonnement parasite infrarouge, par rapport aux technologies CMOS en silicium cristallin.

L'avantage du faible courant de fuite à l'obscurité est conservé quel que soit la taille du pixel. Les mesures faites par la demanderesse et représentées sur le graphe de la figure 13 montrent que avec du silicium polymorphe, les points représentant le courant de fuite à l'obscurité par rapport à la taille du pixel ont sensiblement la même ordonnée : la diminution de la taille du pixel influe peu sur son courant de fuite à l'obscurité.

### Liste des documents cités

[1] Brevet US 6, 114, 739
[2] Article de M. Razeghi et A. Rogalski intitulé "Détecteurs ultraviolet à semi conducteurs"; Applied Physics Revews; 15 mai 1996; pages 7433 à7473.
[3] Brevet US 5,682,037
[4] Article du "Journal of applied physics, Volume 86, number 2 de R. Meaudre et al, Pages 946-950 intitulé "Etat de densité en milieu de bande d'un silicium polymorphe hydrogéné"
[5] Article du "Journal of Non crystalline solid299-302 (2002)page 284 289 de A. Fontcuberta et al.
[6] US 6, 018, 187
[7] Article du "Journal of applied physics, Volume 87, number 4 de R. Vanderhaghen et al, Pages 1874-1881 intitulé "l'origine du gain de courant sous illumination dans les structures n-i-p-i-n en silicium amorphe.
[8] Article de Marko Topic et al - Applied physics letter - Volume 78 - numéro 16, p. 2387-2389

## Revendications

1. Ensemble de capteurs constitué en imageur chaque capteur délivrant un signal correspondant à un pixel de l'image, et ayant,
une brique de détection ayant une zone de détection comportant un matériau photosensible,
une brique d'adressage et éventuellement de traitement de signaux provenant du ou des capteurs, cette brique portant notamment un circuit d'adressage et,
une brique d'interconnexion située entre la brique de détection et la brique d'adressage, cette brique portant des plots de raccordement raccordant des capteurs de l'imageur au circuit d'adressage, en sorte que les signaux provenant des capteurs soient individualisés,
**caractérisé en ce que** le matériau photosensible de la brique de détection contient au moins une couche en silicium polymorphe et **en ce que** des électrodes (64, 94) sont formés au-dessus de plots (5, 5'), ces électrodes ayant une surface inférieure couplée électriquement à un plot (5), et une surface supérieure, la surface supérieure de l'électrode ayant une dimension surfacique plus grande que la surface inférieure au contact du plot.

2. Ensemble de capteurs formant un imageur, selon la revendication 1,
**caractérisée en ce que** la couche en silicium polymorphe a une épaisseur inférieure à 4000 Ångstroms.

3. Ensemble de capteurs formant un imageur, selon l'une des revendications 1 ou 2 **caractérisé en ce que** la brique d'interconnexion est constituée par des plots (5, 5') noyés dans de l'isolant (1, 2, 3).

4. Ensemble de capteurs formant un imageur, selon l'une des revendications 1 ou 2 **caractérisé en ce que** les plots d'interconnexion (5, 5') sont en aluminium ou en cuivre ou en tungstène ou en chrome.

5. Ensemble de capteurs 1 à 3 formant un imageur, selon l'une des revendications 1 à 3 **caractérisé en ce que** le matériau isolant noyant les plots, est constitué par un empilement de couches diélectriques formant des miroirs de Bragg.

6. Ensemble de capteurs formant un imageur, selon la revendication 1, **caractérisé en ce que** la surface supérieure des électrodes présente une forme de cuvette.

7. Ensemble de capteurs formant un imageur, selon l'une des revendications 1, **caractérisé en ce qu'**une partie inférieure de chaque électrode est noyée dans une couche d'isolant, une partie supérieure de cette électrode venant au-dessus de ladite couche d'isolant.

8. Ensemble de capteurs formant un imageur, selon la revendication 7, **caractérisé en ce que** la couche d'isolant entourant une partie inférieure des électrodes est constituée d'un empilement de couches formant miroirs de Bragg.

9. Ensemble de capteurs formant un imageur, selon la revendication 1, **caractérisé en ce que** les électrodes (64, 94) sont en aluminium, ou en cuivre, ou en tungstène, ou en titane, ou en chrome, ou en nitrure de titane, ou en un semi-conducteur dopé, ou en un conducteur organique, ou en un oxyde conducteur, ou enfin encore en un empilement composite des matériaux cités ci-dessus.

10. Ensemble de capteurs formant un imageur, selon la revendication 1, **caractérisé en ce que** la couche de silicium polymorphe (76) est placée au-dessus de la couche comportant l'isolant et les électrodes.

11. Ensemble de capteurs formant un imageur, selon la revendication 10, **caractérisé en ce qu'**au moins une couche supérieure en silicium (79) présente une partie inférieure contenant du carbone et une partie supérieure contenant du bore.

12. Ensemble de capteurs formant un imageur, selon l'une des revendications 1 à 11, **caractérisé en ce que** l'épaisseur de la couche en silicium polymorphe (76) est comprise entre 0,5 et 2 µm.

13. Ensemble de capteurs formant un imageur, selon l'une des revendications 1 à 12, **caractérisé en ce que** la zone de détection comportant le silicium polymorphe est une zone intrinsèque d'une diode PIN ou NIP.

14. Ensemble de capteurs formant un imageur, selon l'une des revendications 1 à 13, **caractérisé en ce que** des électrodes (64, 94) sont formées au-dessus de plots (5, 5'), ces électrodes étant gravées dans une couche de matériau n ou p.

15. Ensemble de capteurs formant un imageur, selon la revendication 9, **caractérisé en ce que** au moins l'une des électrodes contient un matériau dopé n.

16. Ensemble de capteurs formant un imageur, selon la revendication 9, **caractérisé en ce que** au moins l'une des électrodes contient un matériau dopé p.

17. Ensemble de capteurs formant un imageur, selon la revendication 8, **caractérisé en ce que** au moins l'une des électrodes contient un matériau dopé n.

18. Ensemble de capteurs formant un imageur, selon l'une des revendications 1 à 17, **caractérisé en ce que** la couche en matériau polymorphe est une couche intrinsèque placée au-dessus des électrodes.

19. Ensemble de capteurs formant un imageur, selon la revendication 18 en tant qu'elle dépend de la revendication 16, **caractérisé en ce qu'**une couche dopée p est placée au-dessus de la couche en silicium amorphe, réalisant ainsi une diode NIP.

20. Ensemble de capteurs formant un imageur, selon la revendication 18 en tant qu'elle dépend de la revendication 17 **caractérisé en ce qu'**une couche dopée n est placée au-dessus de la couche en silicium amorphe intrinsèque réalisant ainsi une diode PIN.

21. Ensemble de capteurs formant un imageur, selon la revendication 1, **caractérisé en ce que** les plots comportent une surface supérieure métallique, et **en ce que** la couche de matériau polymorphe est placée directement au contact des plots.

22. Ensemble de capteurs formant un imageur, selon la revendication 21, **caractérisé en ce qu'**une couche dopée n est placée au-dessus de la couche en silicium polymorphe.

23. Ensemble de capteurs formant un imageur, selon la revendication 21, **caractérisé en ce qu'**une couche dopée p est placée au-dessus de la couche en silicium polymorphe.

24. Ensemble de capteurs formant un imageur, selon la revendication 23, **caractérisé en ce que** l'électrode est en oxyde transparent conducteur.

25. Ensemble de capteurs formant un imageur, selon la revendication 23, **caractérisé en ce que** l'électrode est réalisée dans une couche d'un métal partiellement transparent au rayonnement ultra violet.

26. Ensemble de capteurs formant un imageur, selon la revendication 23, **caractérisé en ce que** l'électrode supérieure est une grille métallique.

27. Ensemble de capteurs formant un imageur, selon la revendication 23, **caractérisé en ce que** l'électrode est formée par deux peignes ayant chacun des dents, les dents étant interdigitées.

## Claims

1. Assembly of sensors formed as an imager delivering a signal corresponding to one pixel of the image, and having,
a detection brick with a detection zone including a photosensitive material,
a brick for addressing and optionally processing signals from the sensor(s), this brick notably bearing an addressing circuit and,
an interconnection brick located between the detection brick and the addressing brick, this brick bearing connection pads connecting sensors of the imager to the addressing circuit, so that the signals from the sensors are individualized,
**characterized in that** the photosensitive material of the detection brick contains at least a polymorphous silicon layer, and **in that** the electrodes (64, 94) are formed above pads (5, 5'), said electrodes having a lower surface electrically coupled to a pad (5) and an upper surface, the upper surface of the electrode having a surface dimension larger than the lower surface in contact with the pad.

2. Assembly of sensors forming an imager, according to claim 1, **characterized in that** the polymorphous silicon layer has a thickness less than 4,000 Angstroms.

3. Assembly of sensors forming an imager, according to one of the claims 1 or 2, **characterized in that** the interconnection brick is formed by pads (5, 5') embedded in an insulator (1, 2, 3).

4. Assembly of sensors forming an imager, according to claim 1, **characterized in that** the interconnection pads (5, 5') are either in aluminium or copper or tungsten or chromium.

5. Assembly of sensors forming an imager, according to any of claims 1 to 3, **characterized in that** the insulating material embedding the pads, is formed by a stack of dielectric layers forming Bragg mirrors.

6. Assembly of sensors forming an imager, according to claim 1, **characterized in that** the upper surface of the electrodes has a cup shape.

7. Assembly of sensors forming an imager, according to claim 1, **characterized in that** a lower portion of each electrode is embedded in an insulator layer, an upper portion of this electrode appearing above said insulator layer.

8. Assembly of sensors forming an imager, according to claim 7, **characterized in that** the insulator layer surrounding a lower portion of the electrodes consists of a stack of layers forming Bragg mirrors.

9. Assembly of sensors forming an imager, according to claim 1, **characterized in that** the electrodes (64, 94) are either in aluminium or copper or tungsten or titanium or chromium or titanium nitride or a doped semiconductor or an organic conductor or a conducting oxide, or even finally a composite stack of the materials mentioned above.

10. Assembly of sensors forming an imager, according to claim 1, **characterized in that** the polymorphous silicon layer (76) is placed above the layer including the insulator and the electrodes.

11. Assembly of sensors forming an imager, according to claim 10, **characterized in that** at least an upper silicon layer (79) has a lower portion containing carbon and an upper portion containing boron.

12. Assembly of sensors forming an imager, according to any of claims 1 to 12, **characterized in that** the thickness of the polymorphous silicon layer (76) is between 0.5 and 2 µm.

13. Assembly of sensors forming an imager, according to any of claims 1 to 12, **characterized in that** the detection zone including the polymorphous silicon is an intrinsic zone of a PIN or NIP diode.

14. Assembly of sensors forming an imager, according to any of claims 1 to 13, **characterized in that** electrodes (64, 94) are formed above pads (5, 5'), these electrodes being etched in an n or p material layer.

15. Assembly of sensors forming an imager, according to claim 9, **characterized in that** at least one of the electrodes contains a n doped material.

16. Assembly of sensors forming an imager, according to claim 9, **characterized in that** at least one of the electrodes contains a p doped material.

17. Assembly of sensors forming an imager, according to claim 8, **characterized in that** at least one of the electrodes contains a n doped material.

18. Assembly of sensors forming an imager, according to any of claims 1 to 17, **characterized in that** the polymorphous material layer is an intrinsic layer placed above the electrodes.

19. Assembly of sensors forming an imager, according to claim 18, as depending on claim 16, **characterized in that** a p doped layer is placed above the amorphous silicon layer thereby producing a NIP diode.

20. Assembly of sensors forming an imager, according to claim 18, as depending on claim 17, **characterized in that** a n doped layer is placed above the intrinsic amorphous silicon layer thereby producing a PIN diode.

21. Assembly of sensors forming an imager, according to claim 1, **characterized in that** the pads include an upper metal surface, and **in that** the polymorphous material layer is directly placed in contact with the pads.

22. Assembly of sensors forming an imager, according to claim 21, **characterized in that** a n doped layer is placed above the polymorphous silicon layer.

23. Assembly of sensors forming an imager, according to claim 21, **characterized in that** a p doped layer is placed above the polymorphous silicon layer.

24. Assembly of sensors forming an imager, according to claim 23, **characterized in that** the electrode is in a transparent conducting oxide.

25. Assembly of sensors forming an imager, according to claim 23, **characterized in that** the electrode is made in a layer of a metal partly transparent to ultraviolet radiation.

26. Assembly of sensors forming an imager, according to claim 23, **characterized in that** the upper electrode is a metal grid.

27. Assembly of sensors forming an imager, according to claim 23, **characterized in that** the electrode is formed by two combs each having teeth, the teeth being interdigitated.

## Patentansprüche

1. Eine Abbildungsvorrichtung bildende Sensorengruppe, wobei jeder Sensor ein einem Bildpixel entsprechendes Signal liefert, umfassend:
einen Detektionsbaustein mit einer Detektionszone aus photosensiblem Material,
einen Baustein zur Adressierung und eventuellen Verarbeitung von Signalen, die von dem Sensor oder Sensoren stammen, wobei dieser Baustein insbesondere eine Adressierschaltung umfasst, und
einen Verbindungsbaustein, zwischen dem Detektionsbaustein und dem Adressierbaustein befindlich, wobei dieser Baustein Verbindungselemente aufweist, die Sensoren der Abbildungsvorrichtung mit der Adressierschaltung verbinden, um die von den Sensoren stammenden Signale zu individualisieren,
**dadurch gekennzeichnet, dass** das photosensible Material des Detektionsbausteins mindestens eine Schicht aus polymorphem Silicium enthält, und **dadurch**, dass auf Elementen (5, 5') Elektroden (64, 94) ausgebildet sind, wobei diese Elektroden eine elektrisch mit einem Element (5) gekoppelte untere Fläche haben und eine obere Fläche, und die obere Oberfläche der Elektrode dabei eine größere Flächendimension aufweist als die untere Fläche im Kontakt mit dem Element.

2. Eine Abbildungsvorrichtung bildende Sensorengruppe nach Anspruch 1, **dadurch gekennzeichnet, dass** die Schicht aus polymorphem Silicium eine Dicke unter 4000 Å hat.

3. Eine Abbildungsvorrichtung bildende Sensorengruppe nach einem der Ansprüche 1 oder 2, **dadurch gekennzeichnet, dass** der Verbindungsbaustein durch Elemente (5), eingebettet in Isolationsmaterial (1, 2, 3), gebildet wird.

4. Eine Abbildungsvorrichtung bildende Sensorengruppe nach einem der Ansprüche 1 oder 2, **dadurch gekennzeichnet, dass** die Verbindungselemente (5, 5') aus Aluminium oder aus Kupfer oder aus Wolfram oder aus Chrom sind.

5. Eine Abbildungsvorrichtung bildende Sensorengruppe nach einem der Ansprüche 1 bis 3, **dadurch gekennzeichnet, dass** das Isoliermaterial, in das die Verbindungselemente eingebettet sind, durch einen Stapel dielektrischer Schichten gebildet wird, die Bragg-Spiegel bilden.

6. Eine Abbildungsvorrichtung bildende Sensorengruppe nach Anspruch 1, **dadurch gekennzeichnet, dass** die obere Oberfläche der Elektroden muldenförmig ist.

7. Eine Abbildungsvorrichtung bildende Sensorengruppe nach Anspruch 1, **dadurch gekennzeichnet, dass** ein unterer Teil jeder Elektrode in eine Isolierschicht eingebettet ist und ein oberer Teil dieser Elektrode sich über bzw. auf der genannten Isolierschicht befindet.

8. Eine Abbildungsvorrichtung bildende Sensorengruppe nach Anspruch 7, **dadurch gekennzeichnet, dass** die einen unteren Teil der Elektroden umgebende Isolierschicht durch einen Schichtenstapel realisiert wird, der Bragg-Spiegel bildet.

9. Eine Abbildungsvorrichtung bildende Sensorengruppe nach Anspruch 1, **dadurch gekennzeichnet, dass** die Elektroden aus Aluminium oder aus Kupfer oder aus Wolfram oder aus Titan oder aus Chrom oder aus Titannitrid oder aus einem dotierten Halbleiter oder aus einem organischen Leiter oder aus einem leitfähigen Oxid oder auch aus einem Verbundstapel der oben genannten Materialien sind.

10. Eine Abbildungsvorrichtung bildende Sensorengruppe nach Anspruch 1, **dadurch gekennzeichnet, dass** die Schicht aus polymorphem Silicium (76) sich über der das Isoliermaterial und die Elektroden umfassenden Schicht befindet.

11. Eine Abbildungsvorrichtung bildende Sensorengruppe nach Anspruch 10, **dadurch gekennzeichnet, dass** wenigstens eine obere Schicht aus Silicium (79) einen Kohlenstoff enthaltenden unteren Teil und einen Bor enthaltenden oberen Teil aufweist.

12. Eine Abbildungsvorrichtung bildende Sensorengruppe nach einem der Ansprüche 1 bis 11, **dadurch gekennzeichnet, dass** die Dicke der polymorphen Siliciumschicht (76) zwischen 0,5 und 2 µm enthalten ist.

13. Eine Abbildungsvorrichtung bildende Sensorengruppe nach einem der Ansprüche 1 bis 12, **dadurch gekennzeichnet, dass** die das polymorphe Silicium umfassende Detektionszone eine intrinsische Zone einer PIN- oder NIP-Diode ist.

14. Eine Abbildungsvorrichtung bildende Sensorengruppe nach einem der Ansprüche 1 bis 13, **dadurch gekennzeichnet, dass** Elektroden (64, 94) über Elementen (5, 5') ausgebildet sind, wobei diese Elektroden in eine Schicht aus n- oder p-Material geätzt sind.

15. Eine Abbildungsvorrichtung bildende Sensorengruppe nach Anspruch 9, **dadurch gekennzeichnet, dass** wenigstens eine der Elektroden ein n-dotiertes Material enthält.

16. Eine Abbildungsvorrichtung bildende Sensorengruppe nach Anspruch 9, **dadurch gekennzeichnet, dass** wenigstens eine der Elektroden ein p-dotiertes Material enthält.

17. Eine Abbildungsvorrichtung bildende Sensorengruppe nach Anspruch 8, **dadurch gekennzeichnet, dass** wenigstens eine der Elektroden ein n-dotiertes Material enthält.

18. Eine Abbildungsvorrichtung bildende Sensorengruppe nach einem der Ansprüche 1 bis 17, **dadurch gekennzeichnet, dass** die Schicht aus polymorphem Material eine über den Elektroden angeordnete intrinsische Schicht ist.

19. Eine Abbildungsvorrichtung bildende Sensorengruppe nach dem vom Anspruch 16 abhängigen Anspruch 18, **dadurch gekennzeichnet, dass** über der Schicht aus polymorphem Silicium eine p-dotierte Schicht angeordnet ist, zur Realisierung einer NIP-Diode.

20. Eine Abbildungsvorrichtung bildende Sensorengruppe nach dem vom Anspruch 17 abhängigen Anspruch 18, **dadurch gekennzeichnet, dass** über der intrinsischen Schicht aus polymorphem Silicium eine n-dotierte Schicht angeordnet ist, zur Realisierung einer PIN-Diode.

21. Eine Abbildungsvorrichtung bildende Sensorengruppe nach Anspruch 1, **dadurch gekennzeichnet, dass** die Verbindungselemente eine metallische Oberfläche umfassen, und **dadurch**, dass die Schicht aus polymorphem Material direkten Kontakt mit den Verbindungselementen hat.

22. Eine Abbildungsvorrichtung bildende Sensorengruppe nach Anspruch 21, **dadurch gekennzeichnet, dass** über der polymorphen Siliciumschicht eine n-dotierte Schicht angeordnet ist.

23. Eine Abbildungsvorrichtung bildende Sensorengruppe nach Anspruch 21, **dadurch gekennzeichnet, dass** über der polymorphen Siliciumschicht eine p-dotierte Schicht angeordnet ist.

24. Eine Abbildungsvorrichtung bildende Sensorengruppe nach Anspruch 23, **dadurch gekennzeichnet, dass** die Elektrode aus leitfähigem transparentem Oxid ist.

25. Eine Abbildungsvorrichtung bildende Sensorengruppe nach Anspruch 23, **dadurch gekennzeichnet, dass** die Elektrode in einer Schicht aus einem für UV-Strahlung partiell transparenten Metall realisiert ist.

26. Eine Abbildungsvorrichtung bildende Sensorengruppe nach Anspruch 23, **dadurch gekennzeichnet, dass** die obere Elektrode ein metallisches Gitter ist.

27. Eine Abbildungsvorrichtung bildende Sensorengruppe nach Anspruch 23, **dadurch gekennzeichnet, dass** die obere Elektrode durch zwei Kämme gebildet wird, von denen jeder Zähne hat, wobei die Zähne ineinandergreifen.
